**Europäisches Patentamt**

**European Patent Office**

**Office européen des brevets**

(19)

(11)   **EP 1 542 292 A1**

(12)   **EUROPEAN PATENT APPLICATION**
published in accordance with Art. 158(3) EPC

| | |
|---|---|
| (43) Date of publication:<br>**15.06.2005 Bulletin 2005/24** | (51) Int Cl.⁷: **H01L 33/00** |
| (21) Application number: **04735500.3** | (86) International application number:<br>**PCT/JP2004/007873** |
| (22) Date of filing: **31.05.2004** | (87) International publication number:<br>**WO 2004/114420 (29.12.2004 Gazette 2004/53)** |

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **18.06.2003 JP 2003173465**

(71) Applicant: **Sumitomo Electric Industries, Ltd. Osaka (JP)**

(72) Inventor: **NAKAHATA, Seiji, c/o Itami Works Itami-shi, Hyogo 6640016 (JP)**

(74) Representative: **Grünecker, Kinkeldey, Stockmair & Schwanhäusser Anwaltssozietät Maximilianstrasse 58 80538 München (DE)**

(54)   **LIGHT EMITTING DEVICE**

(57)   A light emitting device which has increased light emitting amount without changing its size is provided. The light emitting device is **characterized in that** a semiconductor layer 30 is formed on an uneven surface 1a of an uneven substrate 1. The light emitting device of the invention can be configured such that the uneven substrate and the semiconductor layer are both made of $Al_xGa_yIn_{1-x-y}N$ ($0 \leq x$, $0 \leq y$, $x+y \leq 1$); each of the planes forming the uneven surface of the uneven substrate has at least one plane index selected from among (11-2L) and (1-10L) in which L represents an integer from 1 to 4; and the angle formed between each of the planes forming the uneven surface of the uneven substrate and the base plane is from 35° to 80°.

FIG. 1

**Description**

Technical Field

The present invention relates to a light emitting device that can emit a large amount of light.

Background Art

A light emitting device for three primary colors: "blue", "green" and "red" of visible light can be fabricated by using a group III nitride semiconductor. For example, the formation of an amorphous buffer layer on a sapphire substrate at low temperature, and then, a group III nitride semiconductor crystal grown on the thus-formed amorphous buffer layer has been proposed (for example, Shibata, "Fabrication of LED Based on III-V Nitride and its Applications", Journal of the Japanese Association for Crystal Growth, vol. 29, No. 3, pp. 283 to 287, Sept. 20, 2002).

However, since it uses the sapphire substrate as a substrate, even when a group III nitride semiconductor crystal is epitaxially grown, only crystals of low quality having a large defect density can be obtained. Further, since the sapphire substrate is an insulator, there has been a problem in a resultant large size light emitting device.

In order to solve the aforementioned problem, it has been proposed that a group III nitride semiconductor crystal be grown on a substrate by using a substrate of a group III nitride semiconductor such as n-GaN (for example, Nishida, "AlGaN-based Ultraviolet Light Emitting Diodes", Journal of the Japanese Association for Crystal Growth, vol. 29, No. 3, pp. 288 to 295, Sept. 20, 2002).

Disclosure of the Invention

At present, a sufficient light emitting intensity can not be obtained even by using the aforementioned light emitting device. Under these circumstances, an object of the present invention is to provide a light emitting device in which a light emitting amount is increased without changing the size of the light emitting device.

In order to attain the aforementioned object, the light emitting device according to the present invention is characterized in that a semiconductor layer is formed on an uneven surface of an uneven substrate. On this occasion, the uneven substrate can comprise $Al_xGa_yIn_{1-x-y}N$ ($0 \leq x$, $0 \leq y$, $x+y \leq 1$); each of the planes forming the uneven surface of the uneven substrate has at least one plane index selected from among (11-2L) and (1-10L) in which L represents an integer of from 1 to 4; and the angle formed between each of the planes forming an uneven upper surface of the uneven substrate and the base plane can be from 35° to 80°.

Brief Description of Drawings

Figure 1 shows a schematic cross-sectional diagram of a light emitting device according to the present invention;
Figure 2 shows a schematic cross-sectional diagram of a conventional light emitting device;
Figure 3 is a schematic perspective diagram of an uneven substrate to be used in the present invention;
Figure 4 is a schematic perspective diagram of another uneven substrate to be used in the present invention; and
Figure 5 is a schematic perspective diagram of a conventional substrate.

Best Mode for Carrying Out the Invention

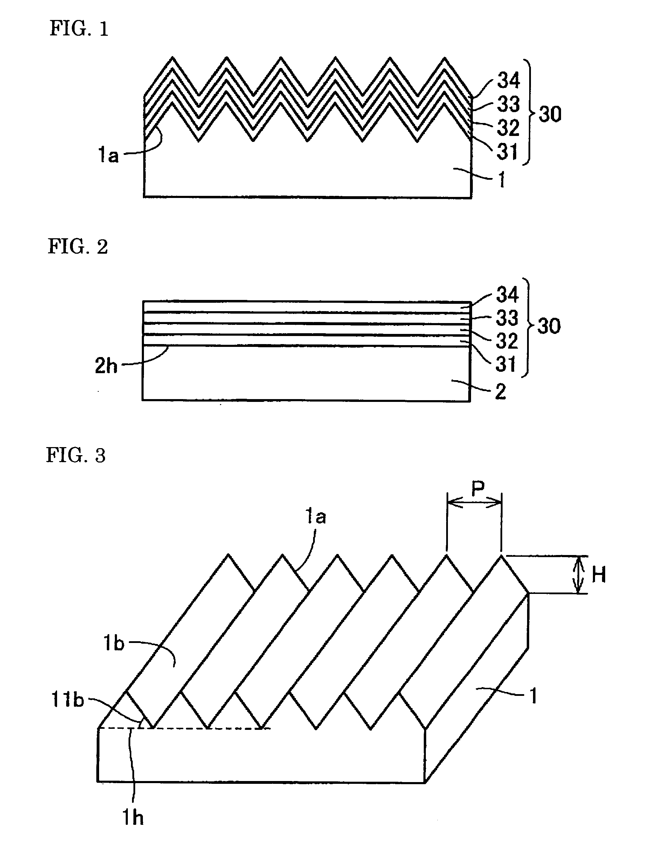

In one light emitting device according to the present invention, in referring to Fig. 1, a semiconductor layer 30 is formed on an uneven surface 1a of an uneven substrate 1. By using such uneven substrate 1 as described above, the surface area of the semiconductor layer 30 for light emission can be large and, accordingly, the light emitting amount of the light emitting device becomes large.

On the other hand, in a conventional light emitting device, in reference to Fig. 2, the semiconductor layer 30 is formed on a planar surface 2h of a plane substrate 2. Namely, in reference to Figs. 1 and 2, since the semiconductor layer 30 of the light emitting device according to the present invention is formed on the uneven surface 1a of the uneven substrate 1, a surface area thereof becomes larger than that of the semiconductor layer 30 formed on the planar surface 2h of the plane substrate 2. In this case, since the semiconductor layer 30 has a constant light emitting amount per unit surface area, by allowing the surface area of the semiconductor layer 30 to be large in such a manner as described above, the light emitting amount can be large without changing the size of the light emitting device.

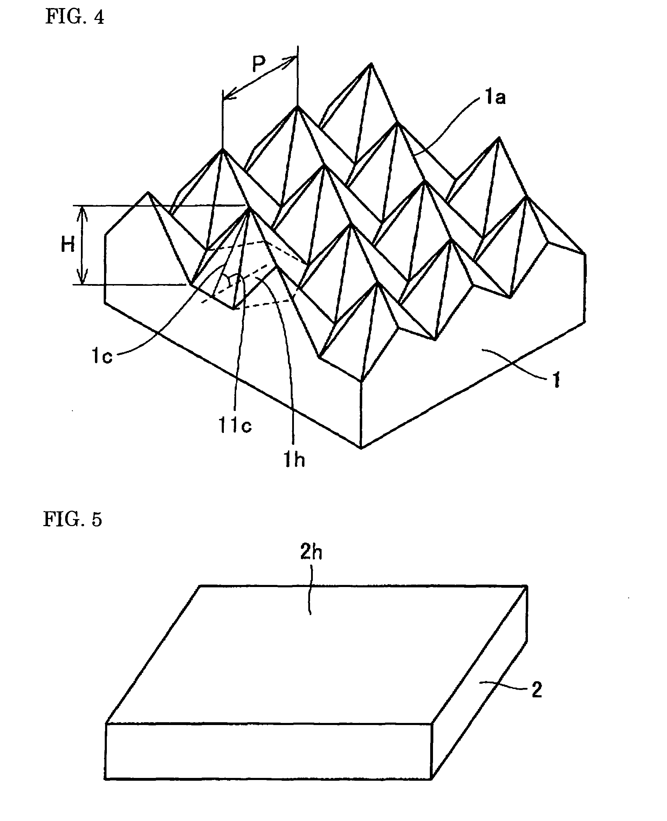

On this occasion, in reference to Figs. 3 and 4, the surface shape of the uneven surface 1a of the uneven substrate 1 is not particularly limited and, for example, the uneven surface 1a having triangular peak portions and triangular valley portions as shown in Fig. 3 is permissible, or the uneven surface 1a in a polyhedral pyramidal shape where one peak region is delineated by a broken line, shown in Fig. 4, is permissible.

Further, peak-valley pitch (horizontal distance between a projection portion and an adjacent projection portion) P in the uneven surface 1a of the uneven substrate 1 and peak-valley height (vertical distance between a recess portion and a projection portion) H are not particularly limited. However, pitch P is preferably from 1 μm to 3000 μm and height H is preferably from 0.1 μm to 3000 μm. When the peak-valley pitch P is less than 1 μm or more than 3000 μm, it becomes difficult to obtain a uniform epitaxial crystal. When the uneven height H is less than 0.1 μm, light emitting area becomes small, while, when it is more than 3000 μm, it becomes difficult to obtain a uniform epitaxial crystal. Under these circumstances, the peak-valley pitch P is more preferably from 1 μm to 500 μm and the peak-valley height H is more preferably from 4 μm to 1500 μm.

In the light emitting device according to the present invention, the uneven substrate and the semiconductor layer each preferably comprise $Al_xGa_yIn_{1-x-y}N$ ($0{\leq}x$, $0{\leq}y$, $x+y{\leq}1$). By constructing the semiconductor layer from $Al_xGa_yIn_{1-x-y}N$ ($0{\leq}x$, $0{\leq}y$, $x+y{\leq}1$) which is a group III compound, the light emitting device for three primary colors: "blue", "green" and "red" of visible light or "ultraviolet" can be fabricated. Further, also in regards to the substrate, by using $Al_xGa_yIn_{1-x-y}N$ ($0{\leq}x$, $0{\leq}y$, $x+y{\leq}1$) here as in the semiconductor layer, a semiconductor layer of good quality can be grown. Still further, the chemical composition of the substrate, that of the semiconductor crystal and a combination of these compositions are not particularly limited and, from the standpoint of obtaining semiconductor layer of good quality, the chemical composition of the substrate and that of the semiconductor layer are favorably similar.

Further, in reference to Figs. 3 and 4, in the light emitting device according to the present invention, it is preferable that each of planes 1b and 1c forming the uneven surface of the uneven substrate has at least one plane index selected from among (11-2L) and (1-10L) in which L represents an integer of from 1 to 4. In the case in which $Al_xGa_yIn_{1-x-y}N$ ($0{\leq}x$, $0{\leq}y$, $x+y{\leq}1$) is used in the substrate and the semiconductor layer, since an $Al_xGa_yIn_{1-x-y}N$ ($0{\leq}x$, $0{\leq}y$, $x+y{\leq}1$) crystal has hexagonal symmetry, there exist six equivalent planes with the same index (11-2L) or (1-10L). On this occasion, L denotes an integer from 1 to 4. Therefore, by using the uneven substrate 1 having the uneven surface 1a comprising such planes as described above, a semiconductor layer of a three-dimensional structure can be formed and, accordingly, the surface area of the semiconductor layer can be large. On this occasion, in the case in which the uneven substrate comprises $Al_xGa_yIn_{1-x-y}N$ ($0{\leq}x$, $0{\leq}y$, $x+y{\leq}1$), a hexagonal pyramid or a triangular pyramid is often the polygonal pyramid formed on the uneven surface 1a as shown in Fig. 4.

Further, in reference to Figs. 3 and 4, in the light emitting device according to the present invention, angles φ 11b and 11c formed between each of the planes 1b and 1c forming the uneven surface 1a of the uneven substrate 1 and a base plane 1h are preferably from 35° to 80°, respectively. In the case in which the $Al_xGa_yIn_{1-x-y}N$ crystal is used as the uneven substrate, a stable peak having an angle of over 80° seldom exists. Further, when the aforementioned angle is less than 35°, the surface area of the semiconductor layer is scarcely increased at all. Here, the base plane 1h denotes a plane perpendicular to a vector in a thickness direction of the uneven substrate 1 and is a plane parallel to a planar surface in a conventional plane substrate.

The $Al_xGa_yIn_{1-x-y}N$ ($0{\leq}x$, $0{\leq}y$, $x+y{\leq}1$) crystal constituting the substrate has a wurtzite-type (hexagonal) crystalline structure and, accordingly, has hexagonal symmetry. Each angle φ formed between each of the planes forming the uneven surface and the angle base plane can be computed by Equation (1) as described below. On this occasion, $(h_1k_1-(h_1+k_1)l_1)$ denotes a plane index of each of the planes forming the uneven surface; $(h_2k_2-(h_2+k_2)l_2)$ denotes a plane index of a base plane (for example, (0001)); $\underline{a}$ denotes $\underline{a}$ axis length; $\underline{b}$ denotes $\underline{b}$ axis length; and $\underline{c}$ denotes $\underline{c}$ axis length. Further, the plane index of each of the planes forming the uneven surface of the uneven substrate and the base plane can be obtained by an X-ray diffraction (hereinafter, referred to as "XRD") method.

Equation 1:

$$\cos\phi = \frac{h_1h_2 + k_1k_2 + \frac{1}{2}(h_1k_2 + h_2k_1) + \frac{3\,a^2l_1l_2}{4\,c^2}}{\left(\left(h_1^2 + k_1^2 + h_1k_1 + \frac{3a^2l_1^2}{4\,c^2}\right)\left(h_2^2 + k_2^2 + h_2k_2 + \frac{3a^2l_2^2}{4\,c^2}\right)\right)^{1/2}} \quad (1)$$

Examples

Hereinafter, a light emitting device according to the present invention will be described in detail with reference to the embodiments.

Example 1

By using a GaN substrate which had an uneven surface 1a having a peak-valley pitch P of 200 μm and a peak-valley height H of 190 μm, as shown in Fig. 3, and in which the plane index of each of the planes 1b forming the aforementioned uneven surface 1a was (1-101), an n-GaN layer 31 of 5 μm, an $In_{0.2}Ga_{0.8}N$ layer 32 of 3 nm, a p-$Al_{0.2}Ga_{0.8}N$ layer 33 of 60 nm and a p-GaN layer 34 of 150 nm were grown on the uneven surface of the aforementioned GaN substrate in this order by a Metal Organic Chemical Vapor Deposition (hereinafter, referred to as "MOCVD") method, to thereby obtain a light emitting device as shown in Fig. 1. A light emitting intensity of the aforementioned light emitting device was measured by using a spectrograph. It has been found that the peak wavelength of a light emitting spectrum of this light emitting device was 470 nm and the light emitting intensity of this light emitting device was 1.9 where the light emitting intensity of Comparative Example 1 to be described below was defined as 1.0. Further, in Example 1, the semiconductor layer was grown on the uneven surface of the uneven substrate by using the MOCVD method. The semiconductor layer can also be grown by using various types of other methods such as Vapor Phase Epitaxy (hereinafter, referred to as "VPE") method and Molecular Beam Epitaxy (hereinafter, referred to as "MBE") method.

(Comparative Example 1)

By using a GaN substrate which has a planar surface 2h (since being planar, peak-valley pitch P is 0 μm and peak-valley height H is 0 μm) as shown in Fig. 5 and in which a plane index of the aforementioned planar surface 2h was (0001), semiconductor layers were grown in the same manner as in Example 1, to thereby obtain a light emitting device as shown in Fig. 2. A light emitting intensity of the aforementioned light emitting device was measured by using a spectrograph. A peak wavelength of a light emitting spectrum of this light emitting device was 470 nm, and then, the light emitting intensity of a blue light emitting device of each of the Examples 1 to 9 was compared with the light emitting intensity of this light emitting device defined as 1.0.

(Examples 2 to 11, Comparative Examples 2 and 3)

A light emitting device having a substrate and a semiconductor layer constitution as shown in Tables I to III was fabricated by using MOCVD method, and then, the wavelength of a light emitting spectrum and light emitting intensity thereof were measured. The results are collectively shown in Tables I to III. Further, an angle $\phi$ in each of the Tables I to III shows the angle as calculated by Eq. 1 from the plane index of each of the planes forming an uneven surface of an uneven substrate and the plane index (0001) of a base plane.

On this occasion, Examples 1 to 9 and Comparative Example 1 in Table I are each an example of a blue light emitting device in which a peak wavelength of a light emitting spectrum is 470 nm and a light emitting intensity of each of the Examples 1 to 9 was indicated as a relative value where the light emitting intensity of Comparative Example 1 was defined as 1.0. Further, Example 10 and Comparative Example 2 in Table II are each an example of a green light emitting device in which the peak wavelength of a light emitting spectrum is 520 nm, and a light emitting intensity of Example 10 was indicated as a relative value where the light emitting intensity of Comparative Example 2 was defined as 1.0; and Example 11 and Comparative Example 3 in Table III are each an example of an ultraviolet light emitting device in which a peak wavelength of a light emitting spectrum is 380 nm, and a light emitting intensity of Example 11 was indicated as a relative value where the light emitting intensity of Comparative Example 3 was defined as 1.0.

Table I

| | Comp. Example 1 | Example 1 | Example 2 | Example 3 | Example 4 | Example 5 | Example 6 | Example 7 | Example 8 | Example 9 |
|---|---|---|---|---|---|---|---|---|---|---|
| Type of substrate | GaN | GaN | GaN | GaN | GaN | GaN | AlN | AlGaN | InN | InGaN |
| Shape of substrate | Fig. 5 | Fig. 3 | Fig. 3 | Fig. 3 | Fig. 3 | Fig. 4 | Fig. 3 | Fig. 3 | Fig. 3 | Fig. 3 |
| P ($\mu$m) | 0 | 200 | 100 | 20 | 50 | 100 | 50 | 20 | 20 | 10 |
| H ($\mu$m) | 0 | 190 | 40 | 33 | 40 | 80 | 45 | 19 | 19 | 9 |
| Plane index | (0001) | (1-101) | (11-24) | (11-21) | (11-22) | (11-22) | (1-101) | (1-101) | (1-101) | (1-101) |
| Angle $\phi$ (°) | 0 | 62 | 39 | 73 | 58 | 58 | 62 | 62 | 62 | 62 |
| Semiconductor layer (thickness nm) | n-GaN(5000)/ $In_{0.2}Ga_{0.8}N(3)$/ p-$Al_{0.2}Ga_{0.8}N$(60)/ p-GaN(150) | n-GaN(5000)/ $In_{0.2}Ga_{0.8}N(3)$/ p-$Al_{0.2}Ga_{0.8}N$(60)/ p-GaN(150) | n-GaN(5000)/ $In_{0.2}Ga_{0.8}N(3)$/ p-$Al_{0.2}Ga_{0.8}N$(60)/ p-GaN(150) | n-GaN(5000)/ $In_{0.2}Ga_{0.8}N(3)$/ p-$Al_{0.2}Ga_{0.8}N$(60)/ p-GaN(150) | n-GaN(5000)/ $In_{0.2}Ga_{0.8}N(3)$/ p-$Al_{0.2}Ga_{0.8}N$(60)/ p-GaN(150) | n-GaN(5000)/ $In_{0.2}Ga_{0.8}N(3)$/ p-$Al_{0.2}Ga_{0.8}N$(60)/ p-GaN(150) | n-GaN(5000)/ $In_{0.2}Ga_{0.8}N(3)$/ p-$Al_{0.2}Ga_{0.8}N$(60)/ p-GaN(150) | n-GaN(5000)/ $In_{0.2}Ga_{0.8}N(3)$/ p-$Al_{0.2}Ga_{0.8}N$(60)/ p-GaN(150) | n-GaN(5000)/ $In_{0.2}Ga_{0.8}N(3)$/ p-$Al_{0.2}Ga_{0.8}N$(60)/ p-GaN(150) | n-GaN(5000)/ $In_{0.2}Ga_{0.8}N(3)$/ p-$Al_{0.2}Ga_{0.8}N$(60)/ p-GaN(150) |
| Light emitting peak wavelength (nm) | 470 | 470 | 470 | 470 | 470 | 470 | 470 | 470 | 470 | 470 |
| Light emitting intensity ratio | 1.0 | 1.9 | 1.2 | 2.5 | 1.9 | 1.9 | 1.7 | 1.9 | 1.7 | 1.8 |

Table II

|  | Comparative Example 2 | Example 10 |
|---|---|---|
| Type of substrate | GaN | GaN |
| Shape of substrate | Fig. 5 | Fig. 3 |
| P (µm) | 0 | 100 |
| H (µm) | 0 | 94 |
| Plane index | (0001) | (1-101) |
| Angle $\phi$ (°) | 0 | 62 |
| Semiconductor layer (thickness nm) | n-GaN(5000)/In$_{0.45}$Ga$_{0.55}$N(3)/p-Al$_{0.2}$Ga$_{0.8}$N(60)/p-GaN(150) | n-GaN(5000)/In$_{0.45}$Ga$_{0.55}$N(3)/p-Al$_{0.2}$Ga$_{0.8}$N(60)/p-GaN(150) |
| Light emitting peak wavelength (nm) | 520 | 520 |
| Light emitting intensity ratio | 1.0 | 2.1 |

Table III

|  | Comparative Example 3 | Example 11 |
|---|---|---|
| Type of substrate | GaN | GaN |
| Shape of substrate P (µm) H (µm) | Fig. 5 0 0 | Fig. 3 50 47 |
| Plane index | (0001) | (1-101) |
| Angle $\phi$ (°) | 0 | 62 |
| Semiconductor layer (thickness nm) | n-GaN(5000)/ n-Al$_{0.2}$Ga$_{0.8}$N (60)/ In$_{0.02}$Ga$_{0.98}$ N(3)/p-Al$_{0.2}$Ga$_{0.8}$ N(60) /p-GaN (150) | n-GaN(5000)/n-Al$_{0.2}$Ga$_{0.8}$N (60)/ In$_{0.02}$Ga$_{0.98}$ N(3)/p-Al$_{0.2}$Ga $_{0.8}$N(60)/ p-GaN(150) |
| Light emitting peak wavelength (nm) | 380 | 380 |
| Light emitting intensity ratio | 1.0 | 1.8 |

As shown in Tables I to III, in the light emitting device, in which the semiconductor layer was formed on the uneven surface of the uneven substrate, according to the present invention, the light emitting intensity has been increased from 1.2 time to 2.5 times, regardless of the light emitting peak wavelength, compared with the conventional light emitting device in which the semiconductor layer was formed on the plane substrate.

It is to be understood that embodiments and examples disclosed herein are illustrative and not restrictive in all aspects. The scope of the invention should be determined with reference to the appended claims and not to the above descriptions and is intended to include meanings equivalent to such claims and all such modifications and variations as fall within the scope of such claims.

Industrial Applicability

As has been described above, in a light emitting device according to the present invention, the light emitting amount can be increased by forming a semiconductor layer on an uneven surface of an uneven substrate, without changing the size of the light emitting device.

**Claims**

1. A light emitting device, being **characterized by** forming a semiconductor layer on an uneven surface of an uneven substrate.

2. The light emitting device as set forth in Claim 1, wherein the uneven substrate and the semiconductor layer com-

prise $Al_xGa_yIn_{1-x-y}N$ ($0{\leq}x$, $0{\leq}y$, $x+y{\leq}1$).

3. The light emitting device as set forth in Claim 1 or 2, wherein each of the planes forming the uneven surface of the uneven substrate has at least one plane index selected from among (11-2L) and (1-10L), wherein L represents an integer from 1 to 4.

4. The light emitting device as set forth in Claim 1 or 2, wherein the angle formed between each of the planes forming the uneven surface of the uneven substrate and the base plane is from 35° to 80°.

FIG. 1

FIG. 2

FIG. 3

FIG. 4

FIG. 5

## INTERNATIONAL SEARCH REPORT

| | International application No. |
|---|---|
| | PCT/JP2004/007873 |

**A. CLASSIFICATION OF SUBJECT MATTER**
Int.Cl⁷ H01L33/00

According to International Patent Classification (IPC) or to both national classification and IPC

**B. FIELDS SEARCHED**

Minimum documentation searched (classification system followed by classification symbols)
Int.Cl⁷ H01L33/00

Documentation searched other than minimum documentation to the extent that such documents are included in the fields searched
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2003-92426 A (Nichia Chemical Industries, Ltd.), 28 March, 2003 (28.03.03), Full text; all drawings (Family: none) | 1-4 |
| X<br>Y | JP 8-222763 A (Sharp Corp.), 30 August, 1996 (30.08.96), Par. Nos. [0020] to [0036]; Fig. 1 (Family: none) | 1,4<br>2-3 |
| X<br>Y | JP 7-15033 A (Japan Energy Corp.), 17 January, 1995 (17.01.95), Par. Nos. [0009], [0012]; Fig. 1 (Family: none) | 1<br>2-4 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 12 August, 2004 (12.08.04) | 31 August, 2004 (31.08.04) |

| Name and mailing address of the ISA/ | Authorized officer |
|---|---|
| Japanese Patent Office | |
| Facsimile No. | Telephone No. |

Form PCT/ISA/210 (second sheet) (January 2004)